# EUROPEAN PATENT APPLICATION

(11) **EP 0 535 742 A2**
(43) Date of publication of application: **07.04.1993**
(21) Application number: 92202958.2
(22) Date of filing: 25.09.1992
(51) Int. Cl.: H04N 5/18

(54) **Signal clamping**

(30) Priority: 02.10.1991 GB 9120950
(71) Applicant: PHILIPS ELECTRONICS UK LIMITED, Croydon CR9 3QR (GB); Philips Electronics N.V., 5621 BA Eindhoven (NL)
(72) Inventor: Redman-White, William, Bassett, Southampton, Hants SO2 3PA (GB); Barth, Paul, c/o INTERNATIONAL OCTROOIBUREAU B.V:, NL-5656 AA Eindhoven (NL)
(74) Representative: Andrews, Arthur Stanley

(57) **Abstract**

A signal source (SV) applies a signal having a fixed low frequency modulation added thereto through a capacitor (CS) to a line (L) to which is connected a first clamping means comprising a first voltage controlled current amplifier or transconductor (A1), a second input of which receives a reference voltage (VR1). The transconductor (A1) output is applied through a first switch means (S1) to the line (L) which switch means (S1) is periodically closed during a defined clamp period in the signal. A filter (BP) is also connected to the line (L) having a pass band centred on the frequency of the modulation which periodically samples the signal during the clamp period. The filter (BP) output is applied to a second transconductor (A2) having a transconductance greater than that of the first transconductor (A1) a second input of which receives a second reference voltage (VR2). The output of the second transconductance (A2) is applied through second switch means (S2) to the line L periodically closed during a defined period in said signal other than the clamp signal.

## Description

The present invention relates to an arrangement for substantially removing from a signal a fixed low frequency modulation which has been previously added to said signal, said arrangement comprising clamping means operable during defined periods in said signal for clamping said signal to a level.

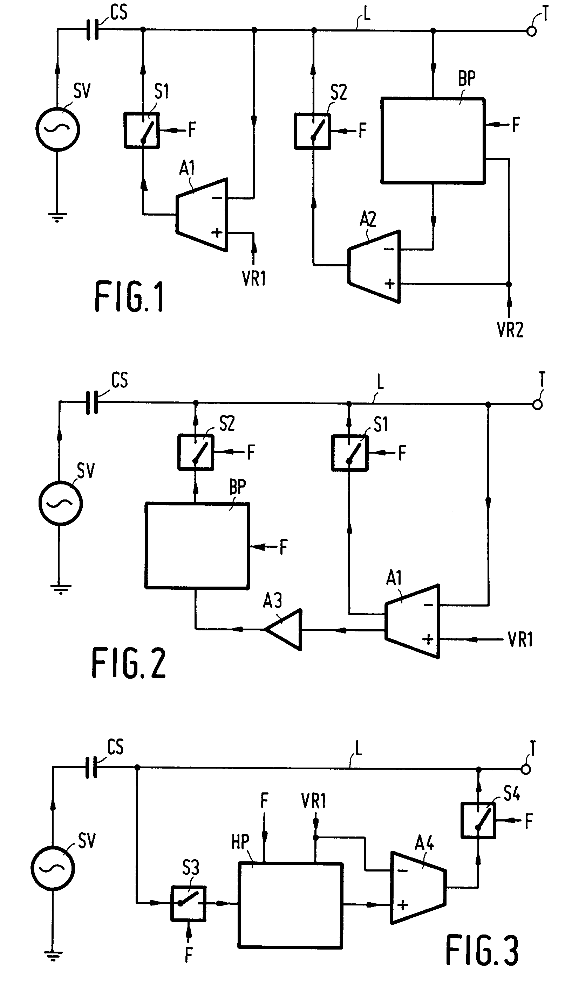

Such an arrangement is incorporated in the Philips Components integrated circuit type TDA 8734 which is an analog signal input conditioner interface designed for use in a multistandard MAC decoder. MAC (multiplexed analog components) vision signals are defined in the European Broadcasting Union (EBU) publication "Specification of the systems of the MAC/packet family", Tech. 3258-E, October 1986, which is incorporated herein by way of reference, and Figures 1a, 1b and 1c on pages 30, 31 and 32 respectively show the approximate video waveforms for a normal unscrambled picture over a line period for the C-MAC, D-MAC and D2-MAC variants of the MAC/packet family. Period c following the synchronisation, sound/data period (period a) and the transition from that period (period b) defines a clamp period of 15 clock periods, at a clock frequency of 20.25 MHz, when the signal is at a grey level of 0.5v for vision signal components of 1v peak amplitude. To provide energy dispersal for a satellite transmission an energy dispersal signal consisting of a frame synchronous triangular waveform of 25Hz is added to the video signal in the case of C-MAC and to the whole baseband signal in the case of D- and D2-MAC. The added dispersal waveforms are shown in figures 2a and 3 on pages 251 and 252 respectively of the above EBU publication for the C- and D2-MAC variants. It is necessary to remove the dispersal waveform from the video components in order to prevent display flicker and this is achieved, to a great extent, by clamping the signal to a fixed reference level during the clamp period. If, however, the time constant of a conventional single pole clamp circuit is optimised for noise suppression during the clamp period then the attenuation of the dispersal signal is limited.

It is an object of the invention to provide an improved arrangement for removing such a dispersal signal.

The invention provides an arrangement for substantially removing from a signal a fixed low frequency modulation which has been previously added to said signal, said arrangement comprising clamping means operable during defined periods in said signal for clamping said signal to a level, characterised in that said clamping means comprises a path in which said signal is periodically sampled during a clamp period of substantially constant amplitude defined in said signal, said clamping means providing a frequency related feedback component for addition to said signal during a further period defined in said signal other than said clamp period.

It has been found that such an arrangement has the advantage that the added low frequency modulation can be more effectively removed from the signal without any significant effect on the noise rejecting properties of the clamping means.

The clamping means may additionally comprise a second path in which said signal is periodically clamped to a reference level during the clamp period. The first mentioned path may comprise a bandpass filter having its pass band centred on the frequency of modulation and a voltage controlled current amplifier, the filter being connected either to an input or to an output of the amplifier a further input of which receives the or a further reference level, and switch means for applying the resulting frequency selected component during the further period. The second path may comprise means for applying the signal to a first input of a second voltage controlled current amplifier a second input of which receives the reference level, the output of the second amplifier being applied through switch means conducting during the clamp periods to a line carrying said signal. The first mentioned amplifier may then have a gain greater than that of the second amplifier.

The first mentioned path may comprise a voltage controlled current amplifier a further output of which is applied to a filter having a pass band centred on the frequency of the modulation, the resulting filtered component being periodically connected to a signal line during the further period, the second path comprising a second output of the amplifier and switch means which during each clamp period provides the reference level to the signal line. The signal from the amplifier may be further amplified before being applied to the band pass filter.

The path may comprise first switch means periodically conducting during the clamp period connected between a signal line and a high pass filter, having its pass band above the frequency of said modulation, to which a reference level is applied, the output of the filter being connected to a first input of a voltage controlled current amplifier whose second input receives the reference level, the output of said ampifier being connected through second switch means periodically conductive during the further period to the signal line.

The signal may be a television signal of the MAC/Packet family where the clamp period is the clamp period of a MAC signal whilst the said further period is the major part of the synchronising, sound/data period of a MAC signal.

The above and other features of the invention will now be described by way of example with reference to the accompanying drawings, in which:-
Figure 1 is a diagram of a first embodiment of an arrangement according to the invention,
Figure 2 is a diagram of a second embodiment of an arrangement according to the invention,
Figure 3 is a diagram of a third embodiment of an arrangement also according to the invention,
Figure 4 is a more detailed version of the diagram of Figure 3, and
Figure 5 is a further detailed version of Figure 3.

The embodiments are described in terms of their usage with signals of the MAC/packet family as specified in the above mentioned EBU publication in which will be found full details for the various members of the family i.e. C-MAC, D-MAC and D2-MAC, as well as the energy dispersal waveform added to these signals when transmissions are via a satellite.

In Figure 1 SV is a source of (say) a D2-MAC/packet signal and is the signal produced by the demodulation of a received transmission from a satellite. Such a demodulated signal retains the 25 Hz triangular waveform energy dispersal component which is to be removed before the demodulated signal is further processed. The signal voltage from source SV is applied through a signal input capacitor CS, which removes the d.c. component, to a first clamp circuit which can be suitably formed within an integrated circuit. However capacitor CS will currently have to be located outside the integrated circuit due to its capacitive value. The signal voltage is applied to the inverting input (-) of a first voltage controlled current amplifier or transconductor A1 whose non-inverting input (+) receives a reference voltage VR1 corresponding to mid grey of the vision signal at which level the signal is to be clamped. The output of the transconductor A1 is applied through a switch S1 to a signal line L carrying the signal, switch S1 being activated at line frequency rate F but only conducting during the above mentioned clamp period (period c) in the MAC signal to provide a d.c. correction component to clamp the signal at the level of the reference voltage VR1.

The signal voltage is also applied to a bandpass filter BP whose output is connected to the inverting input (-) of a second transconductor A2 whose non-inverting input (+) receive a second reference voltage VR2 which is also applied to the bandpass filter BP. The filter BP has its pass band centred at the frequency of 25Hz of the energy dispersal waveform and samples the signal voltage only during the clamp period (period c) of the MAC signal. Filter BP can be a switched capacitor filter feeding the filtered signal to the second transconductor A2 which may have a transconductance which is greater than that of the first transconductor A1. The output of transconductor A2 is applied through a second switch S2 to the signal line L with switch also being activated at line frequency rate F to become conductive to provide an a.c. correction component only during a major part of the above mentioned synchronising, sound/data period (period a) which together with the transition (period b) precede the clamp period (period c). The clamped output from the arrangement appears at terminal T.

Figure 2 is a second embodiment in accordance with the invention and like references used in Figures 1 and 2 indicate like components. In Figure 2 only a single transconductor A1 is used and its configuration within the arrangement is the same as that for Figure 1 with switch S1 again being activated at line rate F and conducting during the clamp period to provide the d.c. correction component. A second output from transconductor A1 is applied to a current amplifier A3 whose output is applied to the band pass filter BP again having its pass band centred at 25Hz and which in this case may be formed by a switched current filter. As with Figure 1, the filter BP samples the signal only during the clamp period (period c) and the output providing the a.c. correction component is applied through switch S2, again conducting at line rate F during the major part of the synchronising, sound/date period (period a), so that at resonance the two circuits act in parallel with each other.

With Figure 1 the band pass filter BP is shown in the connection to the inverting input of transconductor A2 but if formed as a switchable current filter may alternatively be connected between the output of that transconductor and switch S2. In the same way the filter BP in Figure 2 may alternatively be placed between the second output of transconductor A1 and the input of current amplifier A3.

A third embodiment in accordance with the invention is shown in Figure 3 and as with the previous figures like references indicate like components. Figure 3 differs from Figures 1 and 2 in that it only contains a single clamping loop. In the present figure the signal appearing on the signal line L is applied through a switch S3 to a high pass filter HP which also receives the reference voltage VR1. The resulting reference voltage and filtered component are applied to the non-inverting input of a transconductor A4 whose inverting input receives the reference voltage VR1. The transconductor A4 output is applied through a switch S4 to the signal line L. Switch S3 is activated at line rate F and closed during the clamping period (period c) so that filter HP samples the signal during that period only whilst switch S4 is also activated at line rate F and closed during a major part of the synchronising, sound/data period (period a) in the same manner as for Figure 2. The high pass filter HP in combination with transconductor A4 and capacitor CS form a second order high pass filter.

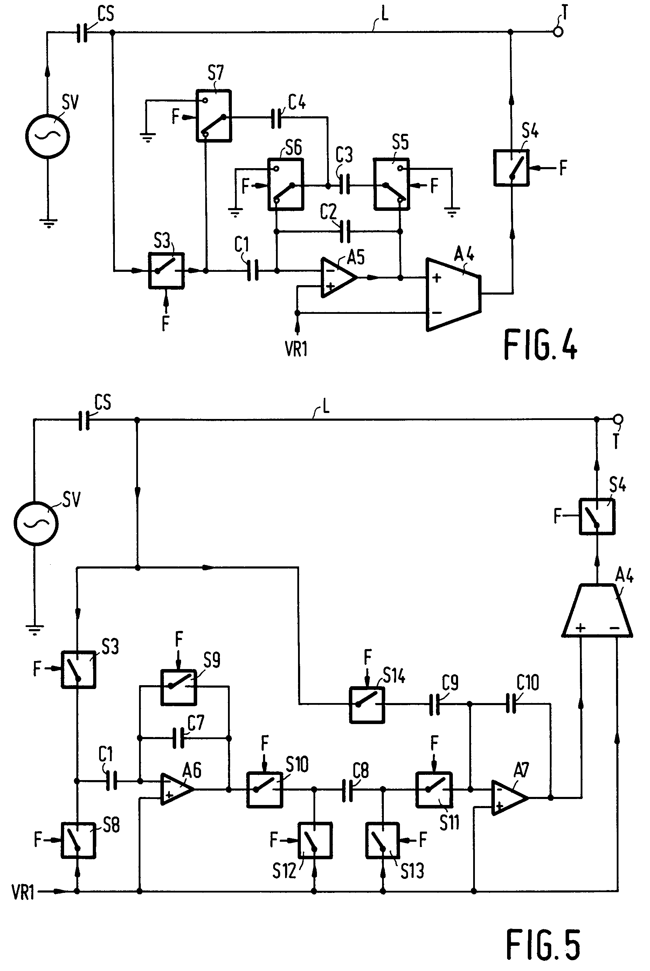

Figure 4 shows the arrangement of Figure 3, and in particular the high pass filter HP, in greater detail. In Figure 4 the high pass filter HP comprises an operational amplifier A5 whose non-inverting (+) input receives the reference voltage VR1. The connection from switch S3 to the inverting (-) input of amplifier A5 is via a capacitor C1 whilst further capacitors C2, C3 and C5 and change over switches S5, S6 and S7 are arranged in the manner shown. Switches S5, S6 and S7 are shown in the positions they occupy during the clamping period (period c) so that during this period capacitors C2 and C3 form a feedback path across amplifier A5 and capacitor C4 shunts capacitor C1. During the major part of the synchronising, sound/data period (period a) when switch S4 is closed, switches S5, S6 and S7 occupy their other positions so that only C2 is in circuit providing a feedback path across amplifier A5. Outside of these two periods the switches are open circuit.

Although the invention has been described in terms of transmissions using signals in the MAC/packet formats it will be appreciated that the arrangement of the invention may be used with transmission whose signals use other formats. Whilst the described embodiments have been for satellite transmissions where a low frequency energy dispersal waveform is superimposed on the actual required signal it could be employed in other areas where an interference signal may be found such as in the case where the signal is transmitted by cable and a mains frequency modulation is unintentionally added to the signal.

Figure 5 shows a further arrangement of Figure 3 with again the high pass filter HP being shown in greater detail. Corresponding references used in Figures 3, 4 and 5 indicate like components. The principal difference between Figures 4 and 5 is that the latter figure employs a two-stage architecture which basically serves to reduce capacitor values only which difference will be described.

With Figure 5 the capacitor C1 feeds into the inverting (-) input of an operational amplifier A6 whose non-inverting input (+) receives the reference voltage VR1, the connection between switch S3 and capacitor C1 being periodically taken to this reference voltage. The output of amplifier A6 which forms an attenuator stage, is fed back to its inverting (-) input via a capacitor C7 which is periodically shunted by a switch S9, this output being periodically connected by way of a switch S10, a capacitor C8 and a further switch S11 to the inverting (-) input of an additional operational amplifier A7 which forms an integrator. Both terminals of capacitor C8 periodically receive through switches S12 and S13 the reference voltage VR1 which is also applied to the non-inverting (+) input of amplifier A7. The output of amplifier A7 provides the input for the non-inverting (+) input of transconductor A4 whilst this output is fed back via a capacitor C10 to the inverting (-) input of amplifier A7. This input also periodically receives the signal appearing on line L by means of a switch S14 and a capacitor C9.

In operation switches S3, S9, S12, S13 and S14 are operated at line rate F and are closed during the clamping period (period C) whilst being open for the remainder of a line period. Switches S4, S8, S10 and S11 are operative at line rate F so that they are closed at a time other than that when the remaining switches are closed and preferably during the synchronising and sound/data period (period a) whilst being open for the remainder of a line period.

From reading the present disclosure, other modifications will be apparent to persons skilled in the art. Such modifications may involve other features which are already known in the design, manufacture and use of the arrangement and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. An arrangement for substantially removing from a signal a fixed low frequency modulation which has been previously added to said signal, said arrangement comprising clamping means operable during defined periods in said signal for clamping said signal to a level, characterised in that said clamping means comprises a path in which said signal is periodically sampled during a clamp period of substantially constant amplitude defined in said signal, said clamping means providing a frequency related feedback component for addition to said signal during a further period defined in said signal other than said clamp period.

2. An arrangement as claimed in Claim 1, characterised in that said clamping means additionally comprises a second path in which said signal is periodically clamped to a reference level during said clamp period.

3. An arrangement as claimed in Claim 2, characterised in that said first mentioned path comprises a bandpass filter having its pass band centred on said frequency of modulation and a voltage controlled current amplifier, said filter being connected either to an input or to an output of said amplifier a further input of which receives the or a further reference level, and switch means for applying the resulting frequency selected component during the said further period.

4. An arrangement as claimed in Claim 2 or 3, characterised in that said second path comprises means for applying said signal to a first input of a second voltage controlled current amplifier a second input of which receives said reference level, the output of said second amplifier being applied through switch means conducting during said clamp periods to a line carrying said signal.

5. An arrangement as claimed in Claim 4 when dependent on Claim 3, characterised in that said first mentioned amplifier has a gain greater than that of said second amplifier.

6. An arrangement as claimed in Claim 2, characterised in that the first mentioned path comprises a voltage controlled current amplifier a first output of which is applied to a filter having a pass band centred on the frequency of said modulation, the resulting filtered component being periodically connected to a signal line during the said further period, said second path comprising a second output of said amplifier and switch means which during each clamp period provides the reference level to the signal line.

7. An arrangement as claimed in Claim 6, characterised in that said signal from said amplifier is further amplified before being applied to said band pass filter.

8. An arrangement as claimed in Claim 1, characterised in that said path comprises first switch means periodically conducting during said clamp period connected between a signal line and a high pass filter having its pass band above the frequency of the modulation, to which a reference level is applied, the output of said filter being connected to a first input of a voltage controlled current amplifier whose second input receives said reference level, the output of said amplifier being connected through second switch means periodically conductive during said further period to said signal line.

9. An arrangement as claimed in any of the preceding claims in which said signal is a television signal of the MAC/Packet family, characterised in that said clamp period is the clamp period of a MAC signal whilst the said further period is the major part of the synchronising, sound/data period of a MAC signal.
